# EUROPEAN PATENT APPLICATION

(11) **EP 0 606 001 A2**
(43) Date of publication of application: **13.07.1994**
(21) Application number: 93310406.9
(22) Date of filing: 22.12.1993
(51) Int. Cl.: H01L 21/331, H01L 21/336, H01L 21/225

(54) **Process of fabrication of bipolar and field effect transistors**

(30) Priority: 28.12.1992 JP 358702/92
(71) Applicant: NEC CORPORATION, Tokyo (JP)
(72) Inventor: Ogawa, Chihiro, Minato-ku, Tokyo (JP)
(74) Representative: Moir, Michael Christopher

(57) **Abstract**

In a process of fabricating a miniature transistor, an undercut is formed beneath a periphery of a doped polysilicon layer (16) over an active area, and a piece of polysilicon (19a) is left in the undercut by etching a polysilicon film covering the entire surface without oxidation for diffusing a dopant impurity from the doped polysilicon (16) through the piece of polysilicon (19a) into the active area (24), thereby preventing the active area from stress.

## Description

### FIELD OF THE INVENTION

This invention relates to a process of fabricating a semiconductor device and, more particularly, to a process of fabricating a miniature transistor on a semiconductor substrate.

### DESCRIPTION OF THE RELATED ART

A prior art process of fabricating a bipolar transistor is disclosed in Japanese Patent Publication of Unexamined Application No. 2-144922, and Figs. 1A to 1D illustrate the prior art process sequence.

The prior art process sequence starts with preparation of a silicon substrate having a lightly doped n-type epitaxial layer 1, and a thick field oxide layer 2 is selectively grown on the major surface of the lightly doped n-type epitaxial layer 1. The thick field oxide layer 2 exposes an active area, and a silicon oxide layer 3 is thermally grown in the active area to thickness of 400 to 600 angstroms.

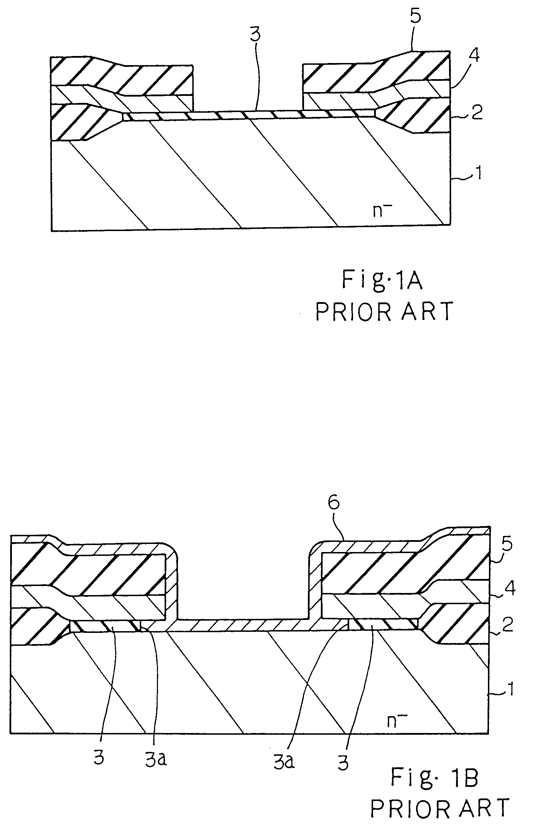

A polysilicon layer 4 is deposited over the entire surface of the structure to thickness of 2500 angstroms to 3500 angstroms, and boron is introduced into the polysilicon layer 4. A silicon nitride layer 5 is deposited on the polysilicon layer 4 to thickness of 2000 to 3000 angstroms, and the doped polysilicon layer 4 and the silicon nitride layer 5 are partially etched away through an anisotropical etching technique so as to expose a part of the silicon oxide layer 3 over an area assigned to emitter and base regions. The resultant structure of this stage is illustrated in Fig. 1A.

Dilute hydrofluoric acid is applied, and the dilute hydrofluoric acid etches away the exposed silicon oxide layer 3. The hydrofluoric acid further etches away the silicon oxide layer 3 beneath the periphery of the doped polysilicon layer 4, and an undercut 3a as wide as 1000 angstroms takes place. Polysilicon is, thereafter, deposited over the entire surface of the structure to thickness of 200 to 300 angstroms, and the undercut 3a is buried in the polysilicon layer 6 as shown in fig. 1B.

The structure is placed in high temperature ambience, and the polysilicon layer 6 is thermally oxidized. Most of the polysilicon layer 6 is converted to a silicon oxide layer 7. However, the polysilicon layer 6 is left in the undercut 3a. While the polysilicon layer 6 is being thermally oxidized, the boron doped into the polysilicon layer 4 is diffused through the polysilicon 6 into the epitaxial layer 1, and p-type base contact region 8 is formed in the lightly doped n-type epitaxial layer 1 as shown in Fig. 1C.

The silicon oxide layer 7 is anisotropically etched, and is partially left on the periphery of the silicon nitride layer 5 and on the periphery of the polysilicon layer 4. The silicon oxide thus left on the peripheries serves as a side wall 7a, and isolates the base contact region 8 and the doped polysilicon layer 4 from an emitter region.

P-type impurity is introduced into an area surrounded by the base contact region 8, and a p-type base region 9 is formed inside of the base contact region 8.

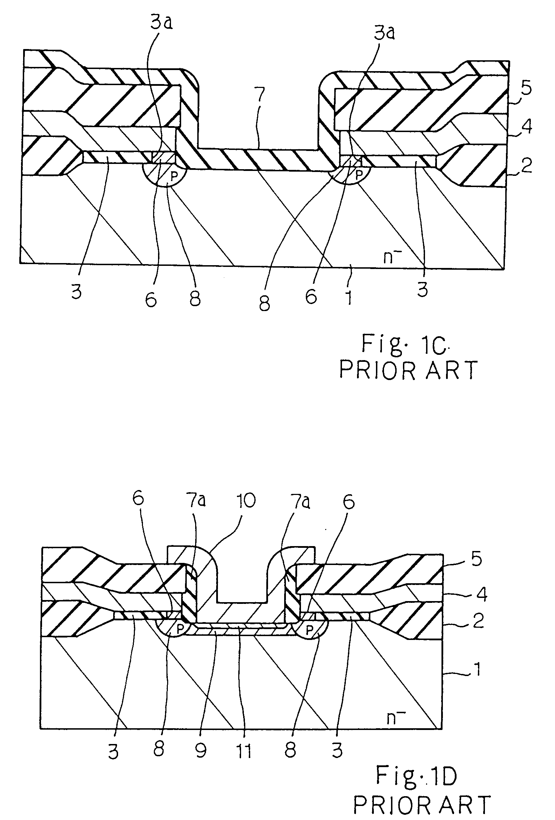

A phosphorus or arsenic-doped polysilicon is patterned to an emitter electrode 10, and the phosphorus or the arsenic is diffused from the doped polysilicon layer for forming an emitter region 11. The resultant structure is illustrated in Fig. 1D.

The prior art process disclosed in the Japanese Patent Publication of Unexamined Application encounters a problem in that the base contact region 8 occupies a wider area than an expected area. This is because of the fact that the boron tends to diffuse over the expected area during the heat treatment stages for the base and emitter regions 9 and 11.

As a result, the prior art bipolar transistor is enlarged, and the integration density is hardly increased. Moreover, the large base contact region 8 is causative of a large amount of parasitic capacitance between the base and the collector, and decreases the breakdown voltage between the emitter and the base.

Another problem inherent in the prior art process is a stress due to the silicon oxide converted from the polysilicon. When the polysilicon layer 6 is converted to the silicon oxide layer 7, the silicon oxide is increased in volume, and the silicon oxide layer 7 presses the lightly doped n-type epitaxial layer 1 beneath the undercut 3a. The stress is causative of crystal defects of the lightly doped n-type epitaxial layer 1 beneath the undercut 3a, and the base contact region 6 suffers from leakage current. The leakage current deteriorates the transistor characteristics.

### SUMMARY OF THE INVENTION

It is therefore an object of the present invention to provide a process of fabricating a miniature transistor or other semiconductor device which is free from the problems inherent in the prior art process sequence.

To accomplish the object, the present invention proposes to leave a piece of semiconductor substance in an undercut by means of an etching process.

Thus in one aspect of the invention provides a process of fabricating a semiconductor device, wherein an undercut is formed beneath a periphery of a doped conductive layer over an active area, and a piece of a second semiconductor substance is disposed in the undercut for diffusing a dopant impurity from the first semiconductor layer through the second semiconductor substance into the active area, characterised by depositing said second conductor substance as a layer over a surface to which the undercut is open, so as to fill the undercut with the second semiconductor substance, and removing said layer except in the undercut by etching without oxidation.

In accordance with another aspect of the present invention, there is provided a process of fabricating a transistor on a semiconductor substrate, comprising the steps of: a) forming a multi-layered structure of a first insulating layer on an active area defined in a major surface of the semiconductor substrate, a first conductive layer of a semiconductor substance doped with a first dopant impurity and formed on the first insulating layer and a second insulating layer formed on the first conductive layer; b) partially removing the second insulating layer and the first conductive layer for forming a hole exposing a first part of the first insulating layer in a central sub-area of the active area; c) etching the first part of the first insulating layer and a second part of the first insulating layer contiguous to the first part and overlain by a periphery of the first conductive layer for forming an undercut beneath the periphery of the first conductive layer; d) depositing a second conductive layer of the semiconductor substance over the entire surface, the undercut being filled with the semiconductor substance; e) etching the second conductive layer except for a piece of the semiconductor substance in the undercut without an oxidation of the second conductive layer; and f) completing the transistor by forming a plurality of impurity regions, at least one electrode and an insulating side wall covering a side surface of the first conductive layer exposed to the hole, a side surface of the second insulating layer exposed to the hole and a side surface of the piece of the semiconductor substance exposed to the hole, one of the plurality of impurity regions being formed through a diffusion of the first dopant impurity from the first conductive layer through the piece of the semiconductor substance into a peripheral sub-area of the active area.

### BRIEF DESCRIPTION OF THE DRAWINGS

The features and advantages of the process of fabricating a miniature transistor according to the present invention will be more clearly understood from the following description taken in conjunction with the accompanying drawings in which:
Figs. 1A to 1D are cross sectional views showing the prior art process sequence;
Figs. 2A to 2G are cross sectional views showing a process sequence for fabricating a miniature transistor according to the present invention;
Fig. 3 is a plan view showing the layout of the miniature transistor fabricated through the process sequence according to the present invention;
Figs. 4A to 4C are cross sectional views showing later stages of a process sequence for fabricating a field effect transistor according to the present invention;
Fig.5 is a plan view showing the layout of a field effect transistor fabricated through the process sequence according to the present invention;
Fig. 6A is a cross sectional view taken along line B-B and showing an undercut filled with polysilicon;
Fig. 6B is a cross sectional view taken along line C-C and showing the undercut filled with polysilicon;
Fig. 7A is a cross sectional view taken along line B-B and showing a piece of polysilicon left in the undercut;
Fig. 7B is a cross sectional view taken along line C-C and showing the piece of polysilicon left in the undercut;
Figs. 8A and 8B are cross sectional view showing later stages of a process sequence for fabricating a lateral bipolar transistor according to the present invention; and
Fig. 9 is a plan view showing the layout of the lateral bipolar transistor fabricated through the process sequence according to the present invention.

### DESCRIPTION OF THE PREFERRED EMBODIMENTS

### First Embodiment

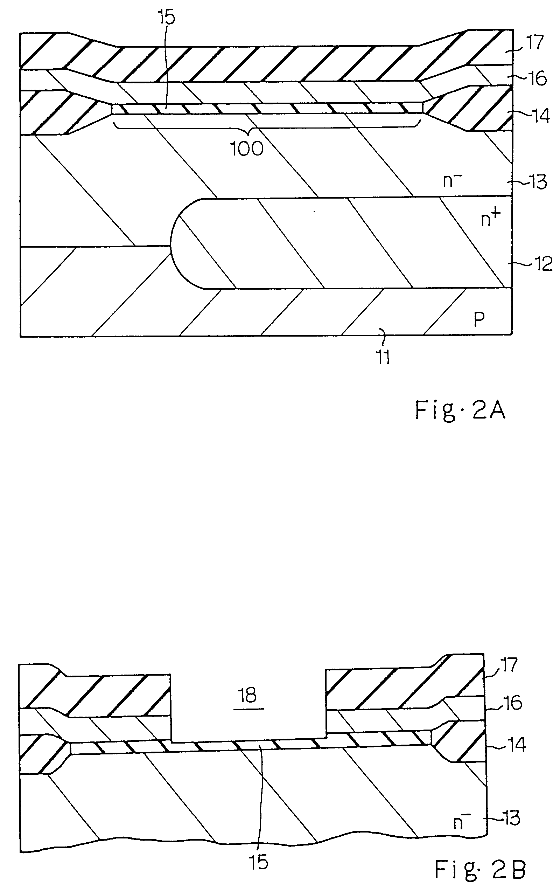

A process sequence for fabricating a miniature bipolar transistor embodying the present invention starts with preparation of a lightly doped p-type silicon substrate 11 shown in Fig. 2A. An n-type impurity is selectively diffused in major surface portion of the p-type silicon substrate 11 for forming a heavily doped n-type buried layer 12, and lightly doped n-type silicon is epitaxially grown over the p-type silicon substrate 11 and the heavily doped n-type buried layer 12 to thickness of 0.6 micron. The lightly doped n-type silicon forms a lightly doped epitaxial layer 13, and the lightly doped epitaxial layer 13 is about 1 ohm-cm.

The lightly doped n-type epitaxial layer 13 is partially oxidized, and a field oxide layer 14 is grown to thickness of 0.1 to 1.5 microns. The field oxide layer 14 defines an active area 100 assigned to a bipolar transistor, and the active area 100 is thermally oxidized so that a silicon oxide layer 15 covers the active area 100. The silicon oxide layer 15 ranges from 20 to 100 nanometers in thickness, and the thickness between 40 to 60 nanometers is desirable.

A p-type polysilicon layer 16 is deposited to thickness 0.1 to 0.4 micron over the entire surface of the structure, and an insulating layer 17 of, for example, silicon nitride is deposited on the p-type polysilicon layer 16 to thickness of 0.15 to 0.40 micron. The resultant structure of this stage is illustrated in Fig. 2A.

The description on the process sequence is continued hereinbelow with reference to Figs. 2B to 2G. However, the p-type silicon substrate 11 and the heavily doped n-type buried layer 12 are deleted from Figs. 2B to 2F for the sake of simplicity.

After the deposition of the insulating layer 17, an appropriate mask is patterned on the insulating layer 17 for covering a periphery of the active area, and the exposed portion of the insulating layer 17 and the exposed portion of the p-type polysilicon layer 16 are anisotropically etched away for forming a hole 18. The hole exposes the part of the silicon oxide layer 15 disposed over a central area assigned to base and emitter regions of the bipolar transistor. The resultant structure of this stage is illustrated in Fig. 2B.

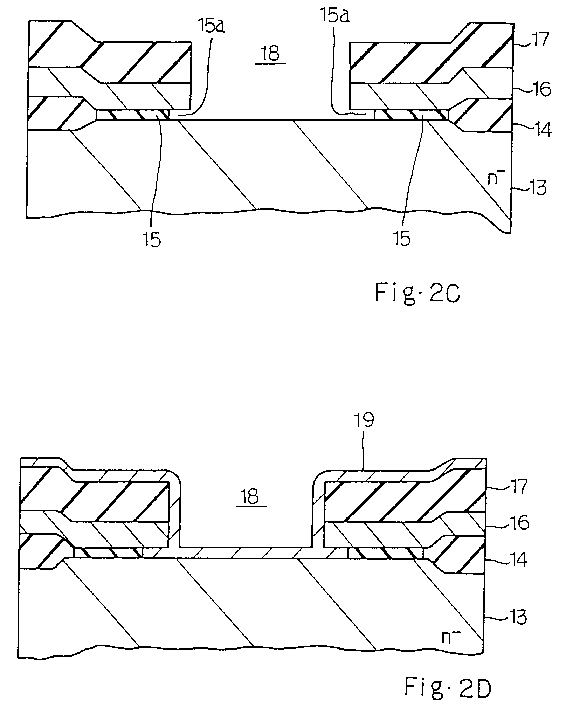

Dilute hydrofluoric acid is applied to the exposed portion of the silicon oxide layer 15. Then, the exposed portion of the silicon oxide layer 15 is etched away in the dilute hydrofluoric acid, and the etching proceeds to the silicon oxide layer beneath the periphery of the p-type polysilicon layer 15. As a result, an undercut 15a is produced beneath the periphery of the p-type silicon oxide layer 16, and the silicon oxide layer 15 is retracted from the inner periphery of the p-type polysilicon layer 16 by 0.1 micron. Fig. 2C illustrates the resultant structure at this stage.

Subsequently, a polysilicon layer 19 is deposited over the entire surface of the structure to thickness not less than a half of the thickness of the silicon oxide layer 15, and the undercut 15a is buried in the polysilicon layer 19 as shown in Fig. 2D.

The polysilicon layer 19 is exposed to a low-energy radical etchant such as, for example, CF₄, and the polysilicon layer 19 is removed. However, a part 19a of the polysilicon layer 19 is left in the undercut 15a, and the low-energy radical etchant does not damage the exposed lightly doped n-type epitaxial layer 13.

Boron is ion-implanted through the hole 18 into the lightly doped n-type epitaxial layer 13 at dose of 2 x 10¹³ cm⁻² under the implantation energy at 10 keV, and a p-type base region 20 is formed in the lightly doped n-type epitaxial layer 13.

The p-type base region 20 may form through another sequence. Namely, a boro-silicate glass film containing boron at 5 mol% is deposited over the entire surface to thickness of 0.1 micron, and is held in contact with the exposed area of the lightly doped n-type epitaxial layer 13. The boro-silicate glass film is heated to 1000 degrees in centigrade through a rapid thermal annealing technique, and is maintained for 20 seconds. Then, the boron is diffused into the lightly doped n-type epitaxial layer 13, and forms the p-type base region 20.

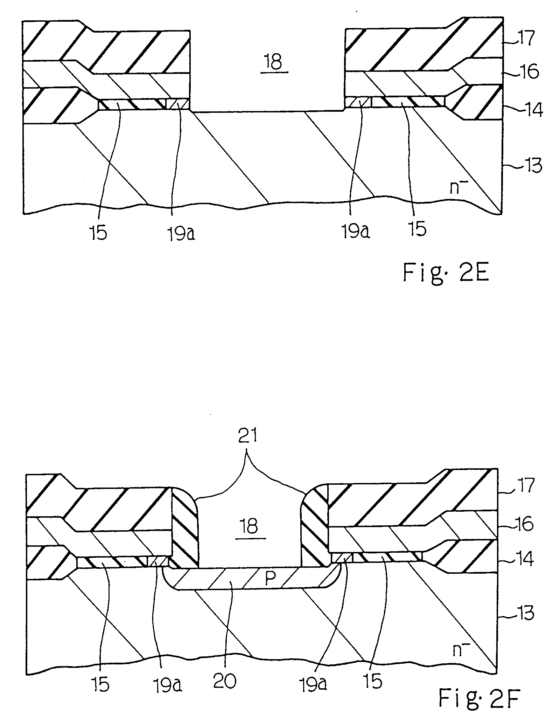

After the formation of the p-type base region 20, an insulating layer is deposited over the entire surface of the structure, and is anisotropically etched away so that a side wall is left on the periphery of the silicon oxide layer 17 and on the periphery of the doped polysilicon layer 16 as shown in Fig. 2F. The side wall 21 electrically isolates the doped polysilicon layer 16 from an emitter electrode.

An n-type doped polysilicon is deposited over the entire surface of the structure, and the n-type doped polysilicon is patterned to an emitter electrode 22. The emitter electrode 22 is held in contact with a central area of the base region 20.

While heating at 1000 degrees to 1050 degrees in centigrade through a rapid thermal annealing, the n-type impurity is diffused from the emitter electrode 22 into the central area of the base region 20, and an n-type emitter region 23 is formed in and nested with the p-type base region 20. Moreover, the n-type impurity is diffused from the doped polysilicon layer 16 through the part 19a of polysilicon into the lightly doped n-type epitaxial layer 13, and a base contact region 24 is partially overlapped with the base region 20 as shown in Fig. 2G.

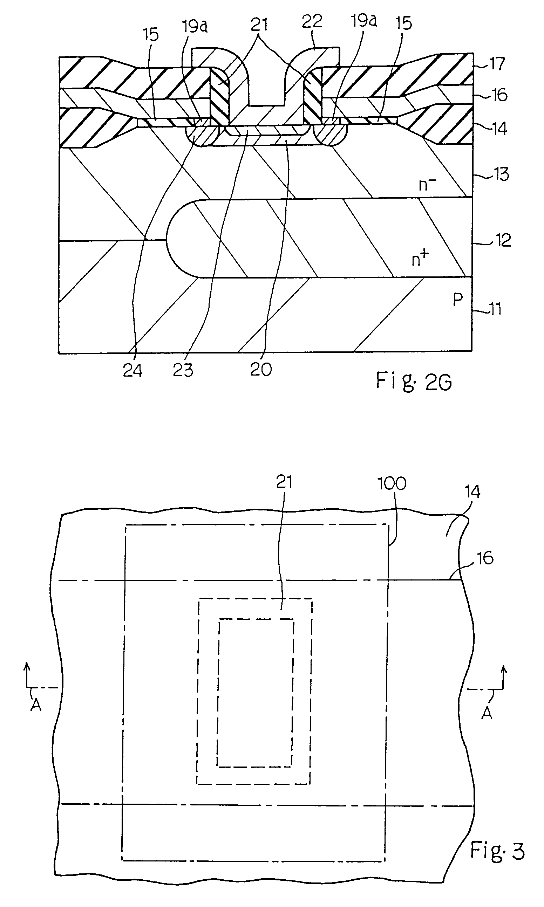

Though not shown in fig. 2G, the emitter electrode 22 is covered with a passivation layer, and the bipolar transistor thus fabricated through the process sequence is fabricated as shown in Fig. 3 which illustrates the relationship in arrangement among the polysilicon layer 16, the side wall 21 and the active area 100. Figs. 2A to 2G are taken along line A-A in Fig. 3.

As will be appreciated from the foregoing description, the process sequence according to the present invention leaves the polysilicon 19a through an etching process, and any stress is not exerted on the lightly doped n-type epitaxial layer 13. This results in an extremely small amount of leakage current and, improves the transistor characteristics.

Moreover, the base contact region 24 is simultaneously formed together with the emitter region 23 at the later stage thereof, and does not expand over an expected area. This results in a small amount of occupation area, and increases the integration density of an integrated circuit device.

### Second Embodiment

The present invention is applicable for a process of fabricating a field effect transistor, and the process sequence is described hereinbelow.

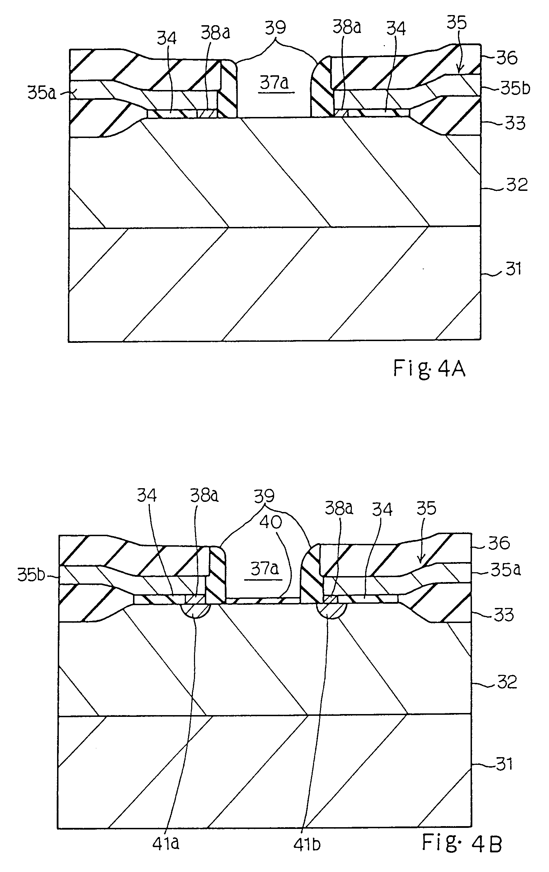

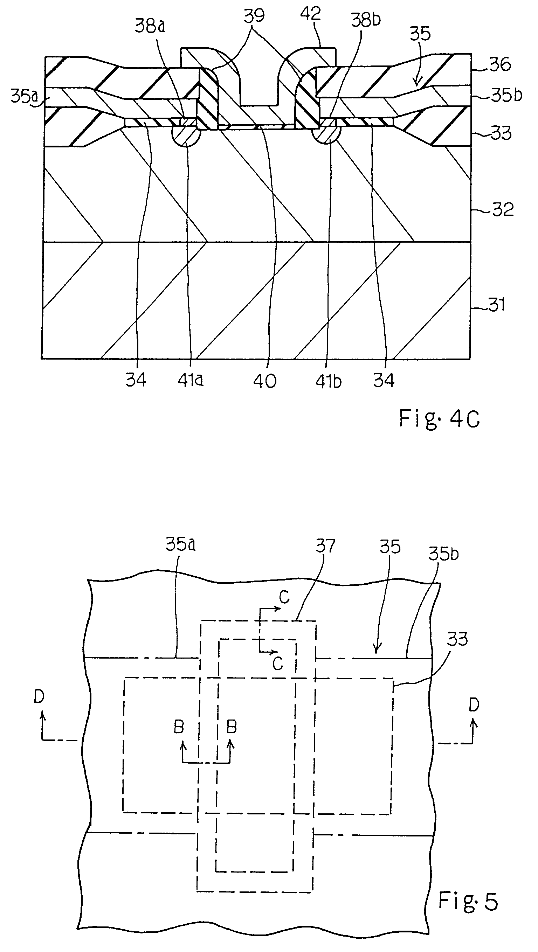

Early stages of the process sequence for fabricating a field effect transistor are similar to those of the process sequence shown in Figs. 2A to 2E, and these figures are used for description on early stages of the second embodiment. Thereafter, the description is made on later stages with reference to Figs. 4A to 4C. Figs. 4A to 4C are cross sectional views taken along line D-D of Fig. 5.

The process for fabricating a field effect transistor starts with preparation of a p-type silicon substrate 31, and a lightly doped n-type epitaxial layer 32 is grown on the p-type silicon substrate 31. A field oxide layer 33 is selectively grown on the lightly doped n-type epitaxial layer 32, and defines an active area assigned to a MIS (Metal-Insulator-Semiconductor) field effect transistor. The active area is, thereafter, thermally oxidized, and a silicon oxide layer 34 covers the active area. A p-type doped polysilicon layer 35 is deposited over the entire surface of the structure, and an insulating layer 36 is, thereafter, deposited over the p-type polysilicon layer 35. The resultant structure at this stage is analogous to that shown in Fig. 2A.

The insulating layer 36 and the p-type polysilicon layer 35 are partially etched away for forming an opening 37 as similar to that shown in Fig. 2B. As will be seen from Fig. 5, the opening 37 is wider than the p-type polysilicon layer 35, and, accordingly, the p-type polysilicon layer 35 is split into two parts 35a and 35b. However, the opening 37 is shorter than the length of the active area, and the leading end portions of the two parts 35a and 35b are on the silicon oxide layer 34. A central portion of the silicon oxide layer 34 is exposed to the opening 37.

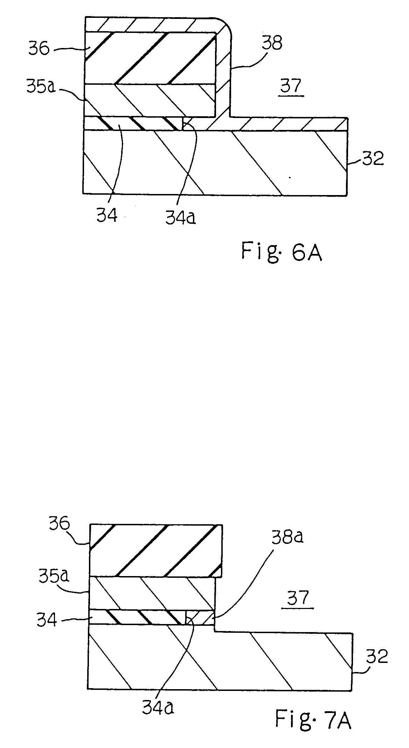

The central portion of the silicon oxide layer 34 is etched away, and the etching further proceeds. As a result, undercuts 34a (see Fig. 6A) are formed beneath the parts 35a and 35b of the p-type polysilicon layer 35. The resultant structure at this stage is analogous to that shown in Fig. 2C.

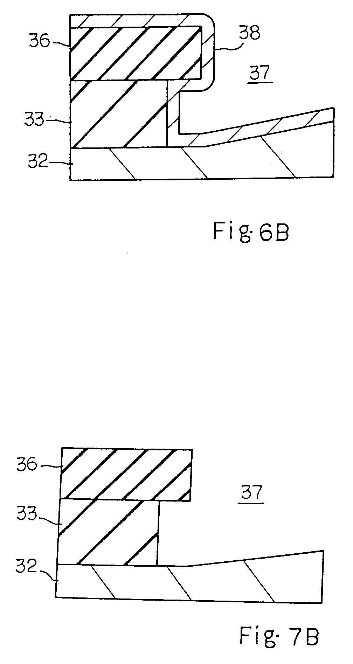

Polysilicon is, thereafter, deposited over the entire surface, and fills the undercuts 34a. The thickness of the polysilicon layer 38 thus deposited is regulated to be not less than a half of the silicon oxide layer 34 and is less than a third of the field oxide layer 33. For this reason, polysilicon layer 38 fills the undercuts 34a beneath the leading end portions of the p-type polysilicon layer 35 as shown in Fig. 6A, but is topological along the field oxide layer 33 as shown in Fig. 6B.

The polysilicon layer 38 is isotropically etched away until the p-type polysilicon layer 35 is exposed, and pieces of polysilicon 38a are left in the undercuts 34a as shown in Fig. 7A. However, the polysilicon layer 38 is perfectly etched away from the side surface of the field oxide layer 33 as shown in Fig. 7B. The resultant structure at this stage is analogous to that shown in Fig. 2E.

Subsequently, insulating substance is deposited over the entire surface of the structure, and the insulating layer is anisotropically etched away until a central sub-area of the active area is exposed again. Then, a side wall 39 is left along the periphery of the opening 37, and the secondary opening 37a exposes the central sub-area as shown in Fig. 4A.

The resultant structure is placed in high-temperature wet ambience at 750 degrees in centigrade, and the central sub-area is thermally oxidized. The silicon oxide layer 40 thus thermally oxidized is 10 to 20 nanometers in thickness. The silicon oxide layer 40 serves as a gate insulating film of the MIS type field effect transistor.

While the central sub-area is being thermally oxidized, p-type impurity is diffused from the p-type polysilicon layer 35 through the pieces of polysilicon 38a into the lightly doped n-type epitaxial layer 32, and source and drain regions 41a and 41b are formed in the lightly doped n-type epitaxial layer 32. The resultant structure at this stage is illustrated in Fig. 4B.

A heavily doped polysilicon is deposited over the entire surface of the structure, and is patterned into a gate electrode 42 as shown in Fig. 4C.

The structure shown in Fig. 4C is finally covered with a passivation layer.

As will be appreciated from the foregoing description, the source and drain regions 41a and 41b are formed simultaneously with the gate insulating film 40, and are hardly diffused over expected areas, because a large amount of heat is not subjected to the source and drain regions 41a and 41b. This results in a miniature MIS type field effect transistor.

Additionally, if the epitaxial layer 32 and the doped polysilicon layer 35 are n-type and p-type, a p-channel type MIS field effect transistor is fabricated through the process sequence according to the present invention.

### Third Embodiment

The present invention is applicable to a process of fabricating a lateral bipolar transistor. The process sequence implementing the third embodiment is similar to that of the second embodiment until the insulating side wall 39 is patterned on the side surfaces, and the component layers and regions are labeled with the same references designating the corresponding layers and regions of the second embodiment.

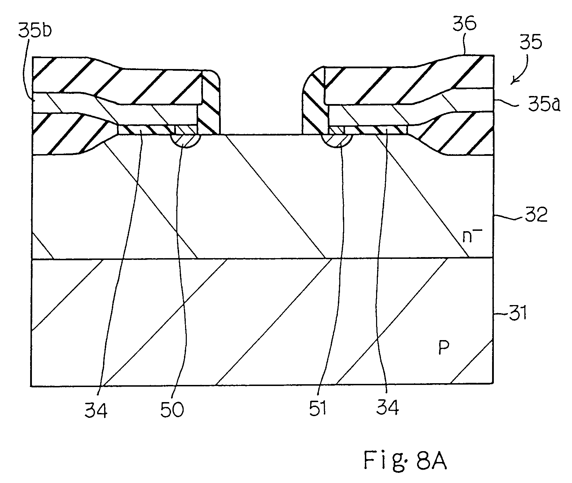

After the formation of the insulating side wall 39, heat is applied to the p-type doped polysilicon 35, and p-type dopant impurity such as, for example, boron is diffused through the pieces of polysilicon 38a and 38b into the lightly doped n-type epitaxial layer 32 for forming emitter and collector regions 50 and 51. The resultant structure at this stage is illustrated in Fig. 8A.

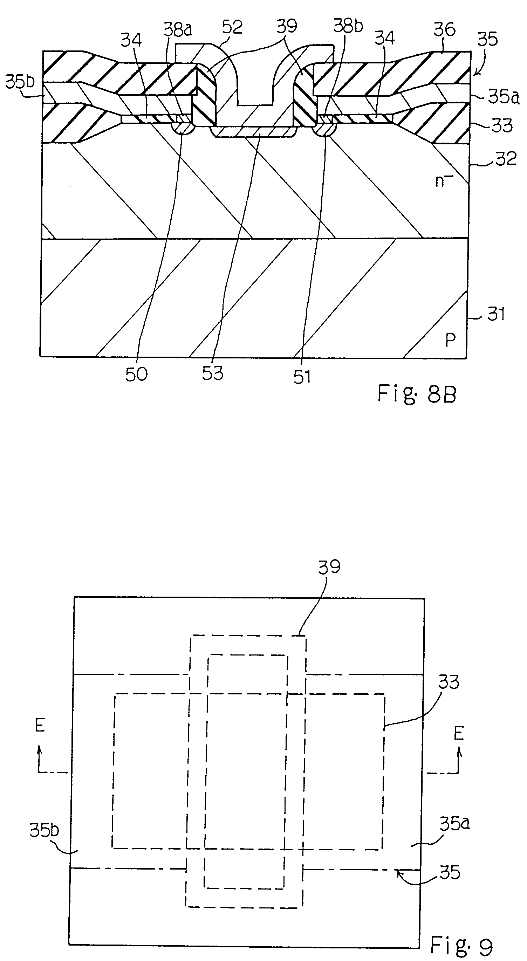

An n-type doped polysilicon layer is deposited over the entire surface of the structure, and is patterned into a base electrode 52. The base electrode 52 is heated through a rapid thermal annealing, and the n-type dopant impurity is diffused from the base electrode 52 into the lightly doped n-type epitaxial layer 32. The n-type dopant impurity thus diffused forms a base contact region 53 as shown in Fig. 8B. The rapid thermal annealing only have small influence on the emitter region 50 and the collector region 51, and the lateral bipolar transistor can be scaled down.

After the formation of the base contact region 53, a passivation layer covers the structure, and a lateral bipolar transistor with the emitter, base and collector electrodes 35b, 52 and 35a is completed.

Fig. 9 illustrates the layout of the lateral bipolar transistor, and the structure shown in Figs. 8A and 8B are taken along line E-E of Fig. 9.

Although the lateral bipolar transistor is a p-n-p type, an n-p-n type lateral bipolar transistor is formed by replacing the p-type doped polysilicon 35 and the n-type base electrode 52 with an n-type doped polysilicon and a p-type base electrode.

As will be under stood from the foregoing description, the emitter region 50 and the collector region 51 are not expanded over expected areas, and a miniature lateral bipolar transistor is fabricated through the process sequence according to the present invention.

Although particular embodiments of the present invention have been shown and described, it will be obvious to those skilled in the art that various changes and modifications may be made without departing from the spirit and scope of the present invention. For example, any p-type dopant impurity and any n-type dopant impurity may be available, and the dimensions do not set any limit on the present invention. Moreover, silicon nitride layers may be available instead of silicon oxide layers.

## Claims

1. A process of fabricating a transistor on a semiconductor substrate (11/12/13; 31/32), comprising the steps of:
a) forming a multi-layered structure of a first insulating layer (15; 34) on an active area defined in a major surface of said semiconductor substrate, a first conductive layer (16; 35) of a semiconductor substance doped with a first dopant impurity and formed on said first insulating layer and a second insulating layer (17; 36) formed on said first conductive layer;
b) partially removing said second insulating layer and said first conductive layer for forming a hole (18; 37) exposing a first part of said first insulating layer in a central sub-area of said active area;
c) etching said first part of said first insulating layer and a second part of said first insulating layer contiguous to said first part and overlain by a periphery of said first conductive layer for forming an undercut (15a) beneath said periphery of said first conductive layer;
d) depositing a second conductive layer (19) of said semiconductor substance over the entire surface, said undercut being filled with said semiconductor substance;
e) removing said second conductive layer except for a piece (19a; 38a) of said semiconductor substance in said undercut; and
f) completing said transistor by forming a plurality of impurity regions (20/23/24; 41a/41b; 50/51), at least one electrode (22; 42;2) and an insulating side wall (21; 39) covering a side surface of said first conductive layer exposed to said hole, a side surface of said second insulating layer exposed to said hole and a side surface of said piece of said semiconductor substance exposed to said hole, at least one (19a; 41a/41b; 50/51) of said plurality of impurity regions being formed through a diffusion of said first dopant impurity from said first conductive layer through said piece of said semiconductor substance into a peripheral sub-area of said active area,
characterized in that
an etching technique selectively removes said second conductive layer without any oxidation stage in said step e).

2. The process as set forth in claim 1, in which said step f) comprises the sub-steps of
f-1) introducing a second dopant impurity through said hole into said semiconductor substrate for forming another of said plurality of impurity regions serving as a base region (20),
f-2) forming said insulating side wall (21) for defining a secondary hole (18),
f-3) forming a third conductive layer (22) doped with a third dopant impurity held in contact with a part of said central sub-area exposed to said secondary hole, said third conductive layer corresponding to said at least one electrode serving as an emitter electrode, and
f-4) applying heat for diffusing said first dopant impurity and said third dopant impurity into said peripheral sub-area and said part of said central sub-area, thereby forming said one (24) of said plurality of impurity regions serving as a base contact region and contiguous to said base region (20) and an emitter region (23) nested with said base region.

3. The process of fabricating a transistor as set forth in claim 1, in which said hole (37) separates said first conductive layer (35) into two portions (35a/ 35b) electrically isolated from each other, and in which
said step f) comprises the sub-steps of
f-1) forming said insulating side wall (39) for defining a secondary hole (37a),
f-2) applying heat for thermally oxidizing a part of said central sub-area exposed to said secondary hole and for diffusing said first dopant impurity into said peripheral sub-area, said part of said central sub-area thermally oxidized serving as a gate insulating film (40), said first dopant impurity diffused into said peripheral sub-area forming said one of said plurality of impurity regions serving as a drain region (41a) and another of said plurality of impurity regions serving as a source region (41b), and
f-3) forming a third conductive layer held in contact with said gate insulating film and corresponding to said at least one electrode serving as a gate electrode (42).

4. The process as set forth in claim 1, in which said hole (37) separates said first conductive layer (35) into two portions (35a/35b) electrically isolated from each other, and in which
said step f) comprises the sub-steps of
f-1) forming said insulating side wall(39) for defining a secondary hole (37a),
f-2) applying heat for diffusing said first dopant impurity into said peripheral sub-area for forming said one of said plurality of impurity regions serving as an emitter region (50) and another of said plurality of impurity regions serving as a collector region (51),
f-3) forming a third conductive layer (52) doped with a second dopant impurity and held in contact with a part of the central sub-area, and
f-4) rapidly heating said third conductive layer for diffusing said second dopant impurity into said part of said central sub-area, thereby forming a base contact region (53) serving as yet another of said plurality of impurity regions.

5. A process of fabricating a semiconductor device, wherein an undercut is formed beneath a periphery of a doped conductive layer (16) over an active area (24), and a piece of a second semiconductor substance (19a) is disposed in the undercut for diffusing a dopant impurity from the first semiconductor layer (16) through the second semiconductor substance (19a) into the active area (24), characterised by depositing said second conductor substance as a layer (19) over a surface to which the undercut is open, so as to fill the undercut with the second semiconductor substance (19a), and removing said layer (19) except in the undercut by etching without oxidation.
